# FASCICULE DE BREVET EUROPEEN

(11) **EP 3 485 349 B1**
(45) Date de publication et mention de la délivrance du brevet: **05.08.2020**
(21) Numéro de dépôt: 17748538.0
(22) Date de dépôt: 12.07.2017
(51) Int. Cl.: G06F 3/01, H01H 13/85

(54) **DISPOSITIF HAPTIQUE METTANT EN OEUVRE UNE LUBRIFICATION PAR VIBRATION**
HAPTISCHE VORRICHTUNG MIT VIBRATIONSBASIERTER SCHMIERUNG
HAPTIC DEVICE USING VIBRATION-BASED LUBRICATION

(30) Priorité: 13.07.2016 FR 1656723
(43) Date de publication de la demande: 22.05.2019
(73) Titulaire: Commissariat à l'Energie Atomique et aux Energies Alternatives (CEA), 75015 Paris (FR)
(72) Inventeur: LEROY, Edouard, 75013 Paris (FR); ECK, Laurent, 28410 Saint Lubin de la Haye (FR); HAFEZ, Moustapha, 94110 Arcueil (FR)
(74) Mandataire: Brevalex
(86) Numéro de dépôt international: PCT/FR2017/051918
(87) Numéro de publication internationale: WO 2018/011522

(56) Documents cités:
- EP-A2- 1 349 050
- US-A1- 2011 115 754
- CHANG ET AL: "Design and implementation of a piezoelectric clutch mechanism using piezoelectric buzzers", SENSORS AND ACTUATORS A: PHYSICAL, ELSEVIER BV, NL, vol. 141, no. 2, 16 octobre 2007 (2007-10-16), pages 515-522, XP022452397, ISSN: 0924-4247, DOI: 10.1016/J.SNA.2007.10.018
- KOYAMA T ET AL: "Development of an ultrasonic clutch for multi-fingered exoskeleton haptic device using passive force feedback for dexterous teleoperation", PROCEEDINGS OF THE 2003 IEEE/RSJ INTERNATIONAL CONFERENCE ON INTELLIGENT ROBOTS AND SYSTEMS. (IROS 2003). LAS VEGAS, NV, OCT. 27 - 31, 2003; [IEEE/RSJ INTERNATIONAL CONFERENCE ON INTELLIGENT ROBOTS AND SYSTEMS], NEW YORK, NY : IEEE, US, vol. 3, 27 octobre 2003 (2003-10-27), pages 2229-2234, XP010675407, DOI: 10.1109/IROS.2003.1249202 ISBN: 978-0-7803-7860-5

## Description

### DOMAINE TECHNIQUE ET ÉTAT DE LA TECHNIQUE ANTÉRIEURE

La présente invention se rapporte à un dispositif haptique mettant en œuvre une lubrification par vibration.

Un dispositif haptique permet à un utilisateur d'avoir une interaction avec une machine par exemple. L'utilisateur ressent un retour haptique lors de la manipulation du dispositif haptique, par exemple sous forme de crans ou de butée mécanique. L'interaction entre l'utilisateur et la machine est alors enrichie et peut être plus intuitive. Le dispositif haptique peut prendre la forme d'un bouton rotatif dans ce cas l'interface oppose un couple résistant à l'utilisateur en fonction de la position angulaire du bouton d'actionnement et du déplacement appliqué par l'utilisateur, permettant ainsi de définir des motifs haptiques qui seront ressentis par l'utilisateur lorsqu'il tourne le bouton.

L'interface haptique peut en variante prendre la forme d'un bouton se déplaçant linéairement. L'interface haptique munie du dispositif haptique présente l'avantage d'être reconfigurable et ainsi de s'adapter à l'interaction en cours.

Il existe plusieurs technologies pour générer ce retour haptique.

Une de ces technologies met en œuvre des moteurs qui génèrent un couple sur le bouton mais ils présentent l'inconvénient d'être encombrants.

Le couple résistant peut être généré par un fluide magnétorhéologique auquel on applique un champ magnétique qui dépend du couple que l'on veut générer. Par exemple plus le champ magnétique est élevé, plus la viscosité du fluide augmente, et plus le couple appliqué au bouton est important. Des dispositifs haptiques mettant en œuvre un tel fluide sont très performants mais ils peuvent présenter un certain encombrement et peuvent comporter un grand nombre de pièces mécaniques.

Une autre technologie est entièrement électrique et met en œuvre un matériau piézoélectrique. Le document Koyama, Tatsuya, Kenjiro Takemura, and Takashi Maeno. "Development of an Ultrasonic Brake." Journal of Advanced Mechanical Design, Systems, and Manufacturing 1, no. 1 (2007): 122-129 décrit un frein ultrasonique pouvant être utilisé dans des dispositifs haptiques. Le frein ultrasonique met en oeuvre un disque piézoélectrique fixé sur un dispositif vibrant, l'ensemble formant un stator, un rotor est disposé sur le disque. En alimentant le disque piézoélectrique de sorte qu'il vibre à une fréquence propre de 21,5 kHz, une vibration hors-plan normale au plan est générée, ce qui génère des ondes de pression et crée un film d'air entre le stator et le rotor. Il y a alors une séparation des surfaces de manière intermittente ou quasi continue.

Ce dispositif requiert un dispositif vibrant relativement épais il en résulte alors un certain encombrement.

Il existe également des interfaces sous forme d'une surface tactile, sur laquelle un doigt se déplace. L'utilisateur ressent un retour haptique en fonction de la position du doigt par exemple. Le retour haptique est généré par des résonateurs piézoélectriques situés sous la surface. Les résonateurs sont excités de sorte que des vibrations ultrasoniques normales à la surface tactile soient générées, ce qui module le frottement ressenti au niveau d'un doigt se déplaçant sur la surface. Ce type d'interface pose des problèmes de conception en termes de capteur de force et de position et en termes d'excitation ultrasonique. En outre, l'effet des vibrations peut ne pas être présent sur toute la surface tactile.

Le document US2011/115754 décrit un dispositif de commande comportant un actionneur passif comprenant un matériau piézoélectrique monté entre une plaque fixe et une plaque mobile. L'actionneur est excité de sorte à générer un mode d'excitation hors-plan, qui crée un film d'air entre la plaque fixe et la plaque mobile.

### EXPOSÉ DE L'INVENTION

C'est par conséquent un but de la présente invention d'offrir un dispositif haptique de structure simple, offrant un retour haptique amélioré et présentant un encombrement réduit.

Le but de la présente invention est atteint par un dispositif haptique comportant un support, un élément d'interaction avec l'utilisateur qui peut être déplacé au moins en rotation et/ou en translation par rapport audit support, une première zone de contact solidaire en mouvement de l'élément d'interaction, une deuxième zone de contact solidaire en mouvement du support, au moins un détecteur de la position de l'élément d'interaction par rapport au support, au moins un résonateur, des moyens d'excitation du résonateur à au moins une fréquence de résonance telle qu'elle génère un mode de vibration dans le plan du résonateur et l'apparition d'un phénomène de lubrification entre la première zone de contact et la deuxième zone de contact.

Le résonateur comporte de préférence un matériau piézoélectrique. En variante il pourrait comporter par exemple un matériau magnétostrictif.

Les inventeurs ont découvert que la mise en œuvre d'un mode de vibration dans le plan était sensiblement plus efficace pour générer une lubrification qu'un mode de vibration orthogonal au plan générant un phénomène de lévitation mis en œuvre par les dispositifs de l'état de la technique. Le mode de vibration dans le plan génère un glissement dans le plan et provoque l'apparition d'une lubrification.

La mise en œuvre d'un mode de vibration dans le plan est particulièrement avantageuse dans le cas d'un bouton haptique rotatif, car les forces tangentielles générées s'additionnent à l'extrémité radiale du résonateur, provoquant une amplification de l'effet de lubrification. La zone au niveau de laquelle la lubrification apparaît peut alors avantageusement être limitée à une zone annulaire.

La mise en œuvre d'un mode de vibration dans le plan ne nécessite pas de dispositif vibrant épais. L'encombrement du dispositif haptique peut être réduit.

Le dispositif haptique peut comporter un élément d'interaction avec l'utilisateur mobile en rotation ou en translation.

De manière très avantageuse, la fréquence de résonance est une fréquence ultrasonique de sorte à générer une lubrification ultrasonique.

La présente invention a alors pour objet un dispositif haptique comportant un support, un élément d'interaction avec l'utilisateur apte à être déplacé au moins en rotation et/ou en translation par rapport audit support, une première zone de contact solidaire en mouvement de l'élément d'interaction, une deuxième zone de contact solidaire en mouvement du support, au moins un premier résonateur, une unité de commande telle qu'elle excite le résonateur à au moins une fréquence de résonance générant un mode de vibration dans le plan et l'apparition d'un phénomène de lubrification par vibration entre la première zone de contact et la deuxième zone de contact.

De manière préférée, la fréquence de résonance est comprise entre 70 kHz et 200 kHz de sorte à générer une lubrification ultrasonique.

Dans un exemple de réalisation, le premier résonateur comporte une plaque et une pastille en un matériau apte à générer des vibrations fixée à ladite plaque, l'une des faces de la première plaque formant la première zone de contact ou la deuxième zone de contact.

Dans un autre exemple de réalisation, le premier résonateur comporte une plaque et une pastille en un matériau apte à générer des vibrations fixée à ladite plaque, l'une des faces de la première plaque formant la première zone de contact et ledit dispositif comportant un deuxième résonateur comprenant une plaque et une pastille en matériau apte à générer des vibrations fixée à ladite plaque, l'une des faces de la première plaque formant la deuxième zone de contact.

Dans un mode de réalisation dans lequel l'élément d'interaction est apte à être déplacé en rotation, la première zone de contact et/ou la deuxième zone de contact peuvent être de forme annulaire.

Dans un mode de réalisation dans lequel l'élément d'interaction est apte à être déplacé en translation le long d'un axe longitudinal, la deuxième zone de contact peut être portée par une poutre suspendue au support et s'étendre le long de l'axe longitudinal et au moins un élément matériau apte à générer des vibrations peut être fixé à la poutre.

Le dispositif peut avantageusement comporter au moins un détecteur de la position de l'élément d'interaction par rapport au support. Le capteur de position est par exemple magnétique.

De manière également avantageuse, le dispositif haptique peut comporter un capteur de détection de l'intention de l'utilisateur afin de détecter les forces exercées par l'utilisateur avant la rotation de l'élément d'interaction. Le capteur de détection de l'intention d'action de l'utilisateur peut par exemple comporter un capteur de couple dans le cas d'un élément d'interaction mobile en rotation.

Selon une caractéristique additionnelle, l'unité de commande peut être un contrôleur électronique de type microcontrôleur, avantageusement associé à un amplificateur et un contrôleur en fréquence.

Dans un exemple avantageux, au moins l'une parmi les première et deuxième zones de contact est en laiton.

Dans un exemple de réalisation, les première et deuxième zones sont maintenues en contact l'une de l'autre par des moyens élastiques.

### BRÈVE DESCRIPTION DES DESSINS

La présente invention sera mieux comprise sur la base de la description qui va suivre et des dessins en annexe sur lesquels:
- la figure 1 est une représentation schématique d'une vue en coupe longitudinale d'un exemple de bouton haptique rotatif selon l'invention,
- la figure 2 est une vue en éclaté d'une réalisation pratique du bouton haptique rotatif de la figure 1,
- la figure 3 est une représentation graphique de la variation du coefficient de frottement entre les surfaces en contact en fonction de l'amplitude de vibration,
- la figure 4 est une représentation graphique de la variation du rapport couple maximal/couple minimal exercé sur l'élément d'interaction en fonction de l'amplitude de vibration,
- la figure 5 est une représentation schématique d'une vue en coupe longitudinale d'un autre exemple de bouton haptique rotatif selon l'invention comportant un seul résonateur,
- la figure 6 est une représentation schématique d'une vue en coupe longitudinale d'un autre exemple de bouton haptique rotatif selon l'invention comportant un seul résonateur,
- la figure 7 est une représentation schématique d'une vue en coupe longitudinale d'un exemple de bouton haptique mobile en translation selon l'invention,
- la figure 8 est une représentation schématique d'une vue en coupe longitudinale d'un exemple de bouton haptique en forme de sphère selon l'invention,
- la figure 9 est une représentation schématique d'une vue de dessus et d'une vue en coupe longitudinale d'un bouton haptique selon un autre exemple de réalisation,
- la figure 10 est une représentation schématique d'une vue en coupe longitudinale d'un autre exemple de bouton haptique en forme de sphère selon l'invention mettant en œuvre un contact linéique,
- la figure 11 est une représentation schématique d'une vue en coupe longitudinale d'un exemple de bouton haptique rotatif selon l'invention mettant en œuvre un contact linéique,
- la figure 12 est une représentation schématique de la zone d'apparition des vibrations dans le plan,
- la figure 13 est une représentation schématique des modes de résonance d'un résonateur comportant des modes de vibrations hors-plan et dans le plan.

### EXPOSÉ DÉTAILLÉ DE MODES DE RÉALISATION PARTICULIERS

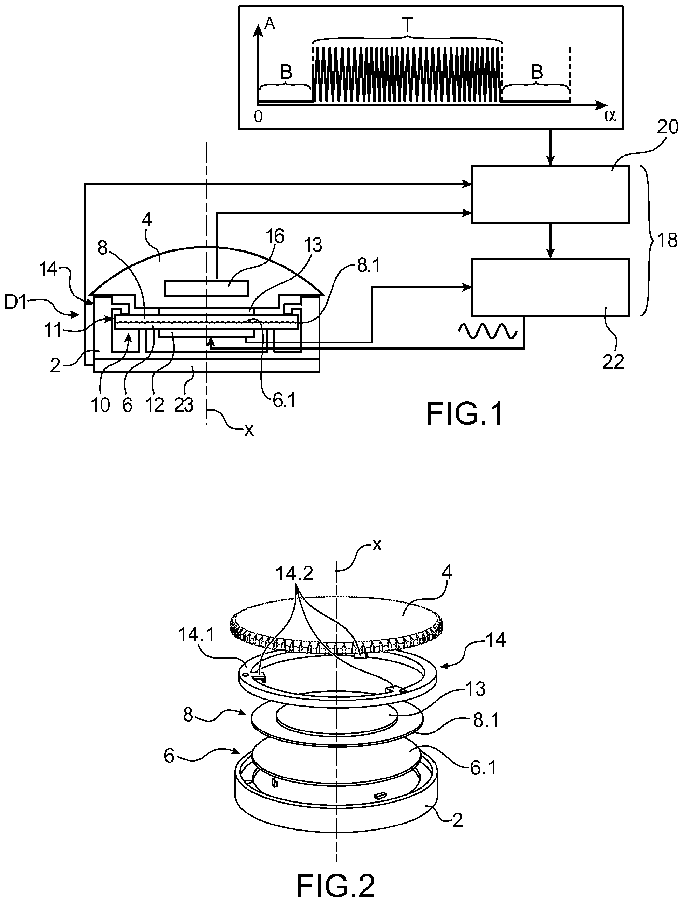

Sur les figures 1 et 2, on peut voir une représentation schématique et en éclaté respectivement d'un exemple de dispositif haptique rotatif selon l'invention. Le dispositif haptique rotatif D1 comporte un boîtier 2 et un élément d'interaction 4 avec l'utilisateur monté apte à pivoter par rapport au boîtier autour d'un axe longitudinal X. L'élément d'interaction 4 sera désigné dans la suite de la description par « bouton ». Le bouton 4 est destiné à être manipulé par un utilisateur, par exemple par un ou plusieurs doigts de l'utilisateur pour au moins le mettre en rotation autour de l'axe X.

Le dispositif comporte au moins un premier résonateur 10 comprenant une plaque 6 et un actionneur 12 en matériau apte à générer des vibrations.

Le matériau apte à générer des vibrations est de préférence un matériau piézoélectrique. En variante il pourrait s'agir par exemple d'un matériau magnétostrictif, par exemple le galfenol.

A des fins de simplicité, le matériau apte à générer des vibrations sera désigné dans la suite de la description par « matériau piézoélectrique ».

Dans l'exemple représenté, le dispositif comporte un deuxième résonateur 11 comportant une deuxième plaque 8 et un actionneur 13 en matériau piézoélectrique.

Les actionneurs 12, 13 sont avantageusement formés par des pastilles en matériau piézoélectrique.

Les résonateurs s'étendent dans deux plans parallèles perpendiculaires à l'axe de rotation.

La première plaque 6 est immobilisée par rapport au boîtier et la deuxième plaque 8 est immobilisée par rapport au bouton, chaque plaque 6, 8 a une forme de disque coaxial à l'axe longitudinal X et comporte une première face 6.1, 8.1 en contact l'une avec l'autre.

La pastille 13 est fixée sur une deuxième face 6.2 de la plaque 6 et la pastille 12 est fixée sur une deuxième face 8.2 de la plaque 8.

De préférence, les plaques 6, 8 sont réalisées dans un matériau résistant à l'usure et offrant un coefficient de frottement entre elles suffisant. Les plaques 6, 8 sont par exemple en laiton. De préférence, le coefficient de frottement en l'absence de vibration entre les deux plaques 6, 8 est supérieur ou égal à 0,25.

En outre, le matériau des plaques est choisi de sorte à présenter de bonnes propriétés acoustiques afin d'offrir un dispositif avec un fonctionnement silencieux ou au moins de niveau sonore réduit.

La pastille piézoélectrique est par exemple en Titano-Zirconate de Plomb (PZT) ou Polyfluorure de vinylidène (PVDF) et par exemple d'épaisseur comprise entre 0,1 mm et 1 mm.

La ou les plaques 6, 8 sont par exemple en laiton, en aluminium ou polymère type époxy.

En variante, on peut envisager de recouvrir au moins les faces des pastilles entrant en contact avec une couche d'un matériau polymère, par exemple de type époxy.

Selon une autre variante, les pastilles sont réalisées en un matériau piézoélectrique résistant à l'usure et présentant un coefficient de frottement suffisant. Les pastilles sont alors directement en contact l'une avec l'autre. Les pastilles pourraient être réalisées par exemple en un matériau polymère ayant des propriétés piézoélectriques.

Chaque pastille ou actionneur piézoélectrique est fixé à la plaque de sorte que les vibrations générées par excitation du matériau piézoélectrique soient transmises à la plaque, l'ensemble formant un résonateur.

De préférence, la première plaque 6 est supportée dans le boîtier par plusieurs zones discrètes, par exemple trois afin de limiter l'amortissement des vibrations appliquées par la pastille. La première plaque 6 est par exemple fixée au boîtier par collage.

De manière avantageuse, le dispositif comporte des moyens pour maintenir plaquer mécaniquement les deux premières surfaces 6.1, 8.1 l'une contre l'autre. Dans l'exemple représenté, il s'agit de moyens élastiques 14 qui appliquent une précharge donnée à la deuxième plaque 8 en direction de la première plaque 6. Dans l'exemple représenté, les moyens élastiques 14 comportent un anneau support 14.1 et des doigts 14.2 en saillie radialement de l'anneau support et venant en appui axial contre la deuxième face 8.2 de la deuxième plaque 8 en direction de la première plaque 6. Les doigts 14.2 appliquent la précharge à la deuxième plaque. La précharge pourrait être réalisée en utilisant des ressorts de compression métallique de type connu ou des ressorts plats de type lame, placés entre le résonateur et le bâti.

La pression exercée par le ressort entre les deux plaques assure la force de freinage maximale du frein lorsqu'il ne fonctionne pas et l'immobilisation des deux plaques en l'absence de lubrification par vibration.

En variante, ces moyens pourraient être magnétiques. D'autres moyens sont aussi envisageables. En variante encore, il pourrait être envisagé que la force d'appui exercée par l'utilisateur remplace tout ou partie de la pression exercée par le ressort ou par d'autres moyens.

Les actionneurs piézoélectriques sont reliés à une source d'énergie de sorte à exciter les actionneurs à une fréquence de résonance telle que le résonateur est mis en vibration selon un mode de vibration dans le plan.

La fréquence de résonance ayant un mode de vibration dans le plan est au moins égale à 10 kHz. De préférence la fréquence de résonance ayant un mode de vibration dans le plan est comprise entre 70 kHz et 200 kHz afin de générer une lubrification ultrasonique. Le niveau sonore du dispositif en fonctionnement est alors réduit.

On entend par « mode de vibration dans le plan », un mode de vibration dans lequel les déplacements générés par excitation du matériau piézoélectrique ont des directions parallèles au plan du résonateur. La direction de la vibration est dans ce cas normale à la direction de précontrainte appliquée par le ressort.

Le dispositif haptique comporte également au moins un capteur de position angulaire 16 du bouton 4 et une unité de commande 18 afin de commander les résonateurs 10, 11 pour réaliser des motifs haptiques (figure 1).

Le capteur de position 16 est tel qu'il permet de détecter la position angulaire du bouton par rapport au boîtier avec une dynamique suffisante pour pouvoir reproduire le motif haptique voulu.

De manière avantageuse le capteur de position est un capteur magnétique, celui-ci présentant les avantages d'être compact et facile à intégrer.

En variante, il pourrait s'agir d'un capteur optique tel qu'une roue optique, ou un capteur de tout autre type présentant une dynamique suffisante.

L'unité de commande 18 est par exemple un contrôleur électronique de type microcontrôleur. Il module le coefficient de frottement apparent en fonction de la position du bouton et d'un motif préétabli. Ce contrôleur est de préférence associé à un amplificateur 20 et un contrôleur en fréquence 22 afin de maintenir l'excitation à la résonance.

La mise en œuvre d'un capteur de position permet l'obtention de sensations réalistes.

Selon une variante de réalisation, on peut prévoir à la place ou en plus d'un capteur de position, une modulation de l'amplitude des vibrations en fonction du temps. Une telle modulation pourrait par exemple permettre à l'utilisateur de compter des secondes ou de ressentir un rythme de musique indépendamment de l'amplitude du mouvement qu'il cause à l'interface.

Le dispositif haptique est destiné à exercer un effort résistant s'opposant aux déplacements du bouton. Cet effort résistant est déterminé à partir de motifs haptiques prédéfinis en fonction du rendu haptique que l'on souhaite reproduire, ces motifs sont enregistrés dans une base de données.

Un motif est défini par un effort résistant ou effort de freinage à appliquer en fonction par exemple des données suivantes:
- la position angulaire courante du bouton,
- le sens de rotation courant du bouton,
- la vitesse de déplacement du bouton.

Un motif haptique est donc un ensemble de valeurs d'effort de freinage à appliquer au bouton, i.e. un ensemble de valeurs définissant le motif, chaque valeur du motif haptique est associée à une position angulaire donnée du bouton et à un sens de rotation du bouton. Chaque valeur d'effort de freinage correspond à une valeur de coefficient de frottement entre les deux plaques 6 et 8, qui correspond à une valeur de l'amplitude de vibration du résonateur qui correspond à une intensité de courant alimentant l'actionneur.

Il sera compris que la même valeur du motif peut être affectée pour des positions angulaires différentes ou dans le cas d'une interface linéaire pour plusieurs positions linéaires différentes. En outre, des valeurs différentes peuvent être affectées suivant le sens de déplacement.

Dans le dispositif selon l'invention, l'effort de freinage maximal est obtenu lorsqu'aucune excitation n'est appliquée au résonateur.

Sur la figure 1, on peut voir une représentation schématique d'un motif haptique qui correspond à une valeur de l'amplitude de vibration A en fonction de la position angulaire α du bouton. Ce motif est enregistré dans une base de données accessible par l'unité de commande 18. Les zones désignées B correspondent à la simulation de butées et la zone désignée T correspond à la simulation d'une surface texturée.

Une butée virtuelle est définie par un motif haptique pour lequel un effort de freinage très élevé est appliqué au bouton, i.e. en l'absence d'excitation, afin que le bouton ne puisse pas se déplacer dans un sens donné. La butée virtuelle est définie par une zone angulaire à l'intérieur de laquelle doit s'appliquer le motif haptique et par un sens de rotation donné du bouton.

De manière très avantageuse, le dispositif haptique comporte également un capteur 23 de détection de l'intention de l'utilisateur afin de détecter les forces exercées par l'utilisateur avant la rotation du bouton. On détecte alors avantageusement l'information sur le sens de rotation de manière précoce ce qui permet d'améliorer le rendu haptique. Cette détermination de l'intention d'action de l'utilisateur peut être faite en mesurant la force exercée sur le bouton grâce à la déformation d'un élément de l'interface, il s'agit de la mesure d'un couple dans le cas d'un bouton rotatif. Cette information permet donc d'enrichir les simulations possibles, en particulier la simulation de butée à partir de motifs haptiques de type butée.

Le fonctionnement du dispositif haptique est le suivant.

L'utilisateur déplace le bouton 4 autour de l'axe X, le capteur de position et avantageusement le capteur d'intention d'action de l'utilisateur détectent la position angulaire du bouton et avantageusement le sens dans lequel l'utilisateur a l'intention d'agir sur le bouton respectivement. Ces informations sont envoyées à l'unité de commande 18 qui génère un ordre en fonction du motif haptique à reproduire. Le ou les actionneurs sont alimentés en courant ou en tension dont la fréquence est telle que le ou les résonateurs soient excités à une fréquence proche de ou égale à une de leurs fréquences de résonance correspondant à un mode de vibration dans le plan. Pour un tel mode de vibration, les vibrations générées sont tangentielles à la surface. Les forces sont générées dans le plan entre la partie fixe et la partie mobile, et les amplitudes des déplacements s'additionnent à l'extrémité radiale des résonateurs, provoquant un déplacement dans le plan de cisaillement, i.e. normal à la précharge, il en résulte un glissement tangentiel radial perpendiculaire à la direction de rotation et un effet de lubrification ultrasonique entre la partie fixe et la partie mobile. Les deux surfaces restent sensiblement en contact, indépendamment de la force d'appui exercée sur le bouton 4 et le coefficient de frottement entre les deux pastilles est fortement diminué. L'utilisateur peut tourner le bouton presque sans frottement.

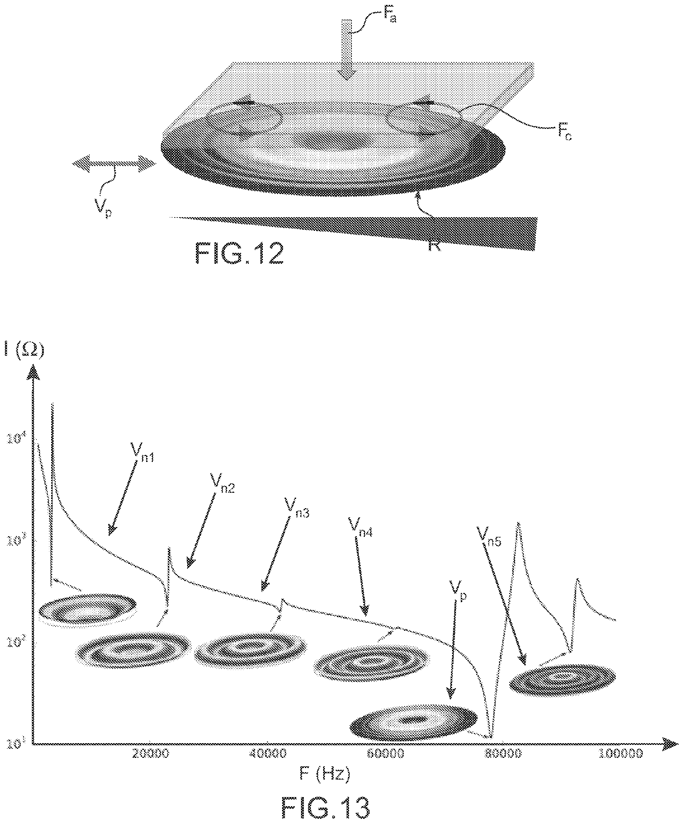

Sur la figure 12, on peut voir une représentation schématique de la zone de contact. Sont représentées les vibrations tangentielles au plan Vp du fait du mode dans le plan et les forces de cisaillement en résultant Fc. Fa est la force d'appui exercé sur l'élément d'interaction ou bouton. Dans cette représentation, un seul résonateur R est utilisé.

Le ou les matériaux du ou des actionneurs subissent des déformations avec des zones de compression et des zones de dilatation dans le plan.

Pour un matériau donné, de dimensions données et de conditions aux frontières (encastrement, contrainte) données, la vibration tangentielle i.e. dans le plan, s'obtient pour une ou des fréquences spécifiques. Pour un matériau mince, i.e. présentant une épaisseur faible par rapport à ses autres dimensions, cette fréquence est généralement supérieure à celle faisant apparaître le premier mode de résonnance vibratoire normale i.e. hors plan.

Sur la figure 13, on peut voir une représentation des modes de résonance d'un résonateur, à partir de la variation de l'impédance I en Ohm en fonction de la fréquence F en Hz. Dans cet exemple, l'apparition d'un mode de vibration dans le plan Vp, i.e. dans le plan a lieu vers 78 kHz, alors que la première fréquence Vn1 à laquelle apparaît un mode de vibration hors plan ou normal au plan est 5 kHz, les autres fréquences représentées correspondent également à des modes de vibration hors-plan Vn2, Vn3, Vn4, Vn5.

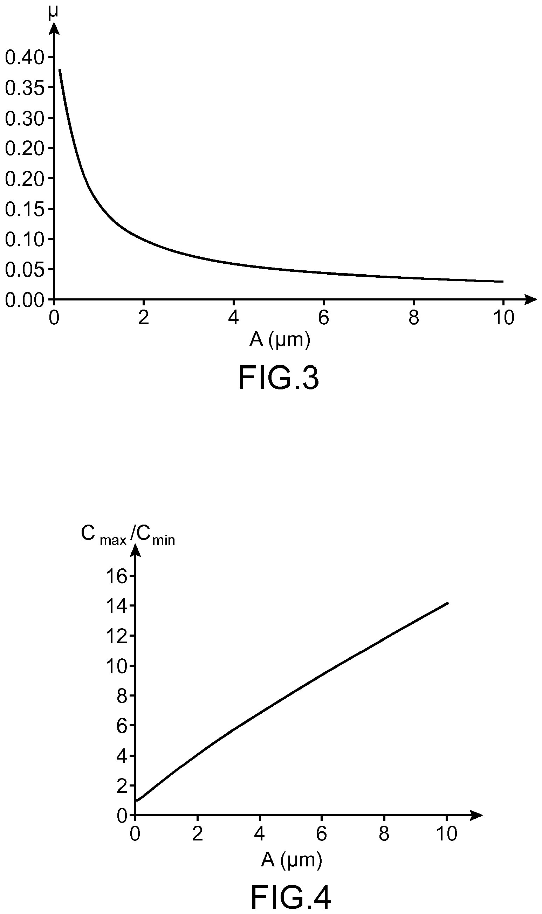

Sur la figure 3, on peut voir représentée l'évolution du coefficient de frottement en fonction de l'amplitude tangentielle de vibration en µm pour un bouton de diamètre de 35mm en estimant la vitesse maximale angulaire atteinte à 1 tr/s (V₀max=0,1m/s). La fréquence de résonance est de l'ordre de 75 kHz.

En général, avec les actionneurs mis en œuvre on peut atteindre une amplitude tangentielle de l'ordre de 3 µm. Pour une telle amplitude, le coefficient de frottement est fortement abaissé.

Sur la figure 4, on peut voir l'évolution du rapport entre le couple maximal et le couple minimal Cmax/Cmin appliqués sur bouton en fonction de l'amplitude tangentielle de la vibration. Pour une amplitude de l'ordre de 3 µm, on obtient un rapport de couple de 5. Le couple qui peut donc être exercé sur le bouton est d'autant plus grand que le coefficient de frottement diminue, et donc que l'amplitude de vibration augmente.

Le type de sensation simulée peut être choisi en faisant varier l'amplitude de la vibration comme cela est illustré par la figure 3. En augmentant ou en diminuant l'amplitude de la vibration, on diminue ou on augmente les frottements respectivement. L'unité de commande modifie donc l'amplitude de vibration en fonction de la position du bouton suivant le motif haptique à reproduire. L'amplitude de vibration dépend de la norme du courant ou de la tension d'excitation alimentant le ou les actionneurs.

En outre, en modulant la fréquence spatiale de la vibration, i.e. en modifiant la variation de l'amplitude de la vibration en fonction du déplacement du bouton, il est possible de modifier la sensation ressentie par l'utilisateur. Par exemple, lorsque la vibration est modulée a une fréquence spatiale élevée, par exemple inférieure au mm, on peut reproduire une sensation de texture, et lorsque la vibration a une fréquence spatiale faible, par exemple supérieure au mm, on peut reproduire des crans individuels.

Contrairement aux dispositifs haptiques à fluide magnétorhéologique par exemple, en l'absence d'alimentation électrique le bouton est freiné, en d'autres termes il est normalement freiné, la lubrification n'apparaissant que lorsque l'actionneur est alimenté électriquement. Dans un dispositif haptique à fluide magnétorhéologique, la viscosité du fluide et donc la force de freinage augmentent avec le champ magnétique. En l'absence de champ, seul le frottement du fluide magnétorhéologique à l'état repos est responsable du freinage.

Dans un exemple de réalisation avantageux, le ou les résonateurs du dispositif comportent un disque en matériau piézoélectrique et un anneau. En effet, comme expliqué ci-dessus le déplacement dans le plan a lieu au niveau du bord radial extérieur du résonateur. Un contact annulaire peut donc être suffisant. Dans le cas d'un dispositif à deux résonateurs, l'autre résonateur peut avoir la même structure ou alors comporter une plaque vibrante fixée à une pastille piézoélectrique. Dans le cas d'un dispositif à un résonateur, la surface en regard pourrait être formée d'une plaque ou d'un anneau.

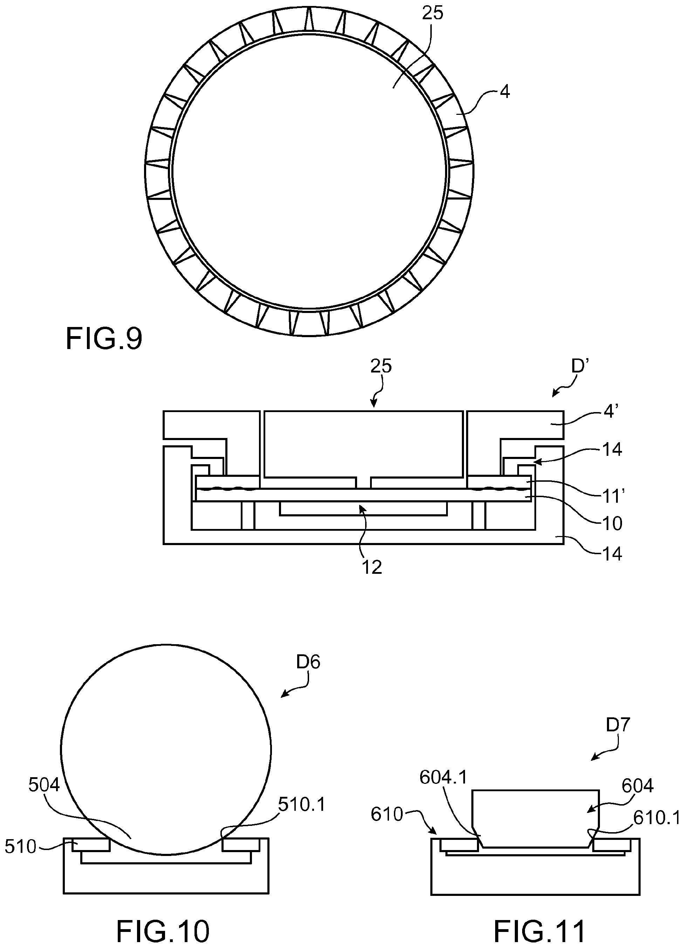

Sur la figure 9, on peut voir un dispositif D1' qui diffère de D1 en ce que le résonateur 11' a une forme d'anneau. Le bouton 4' présente également une forme d'anneau.

De manière avantageuse et comme cela est représenté sur la figure 9, la zone à l'intérieur du résonateur annulaire et du bouton 4' est utilisée pour placer un dispositif d'affichage de type cadran de montre ou écran tactile 25, ou bien inclure d'autres boutons de contrôle (musique, etc...).

Il sera compris qu'un dispositif comportant un résonateur unique annulaire ou identique à un des résonateurs 10 et 11 du dispositif D1 et la surface en regard par exemple solidaire en mouvement du bouton formée uniquement d'un anneau ne sort pas du cadre de la présente invention.

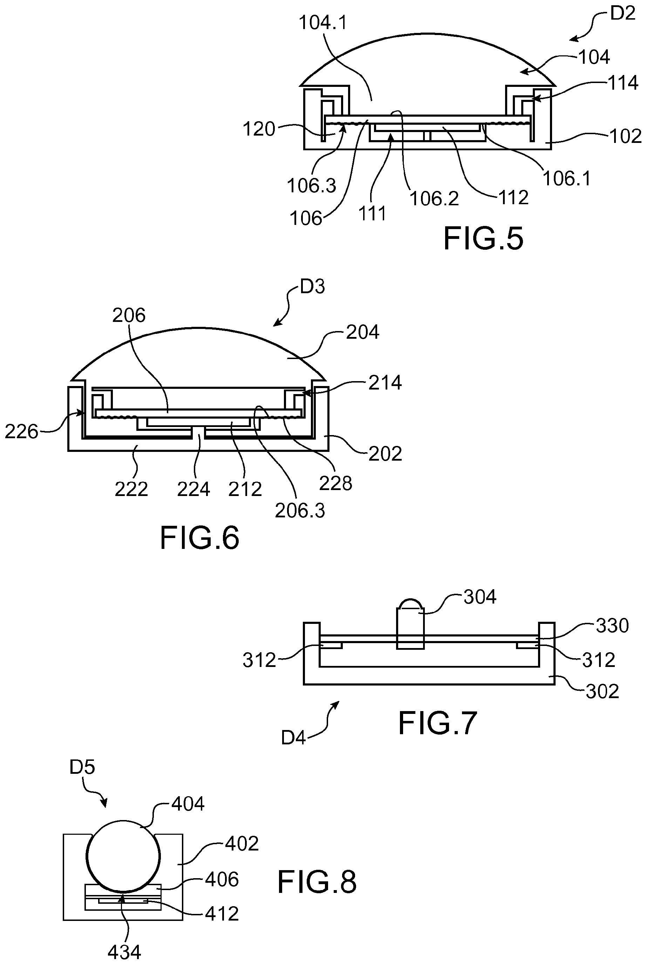

Sur la figure 5, on peut voir un autre exemple de réalisation d'un dispositif haptique selon l'invention.

Le dispositif D2 comporte un boîtier 102, un bouton 104 monté apte à pivoter autour d'un axe longitudinal X par rapport au boîtier et un résonateur 111.

Le résonateur 111 comporte une plaque 106 en forme de disque, solidaire en rotation du bouton et une pastille piézoélectrique 112 fixée sur la première face 106.1 de la plaque 106. Le bouton 104 comporte une saillie axiale 104.1 fixée à une zone centrale de la deuxième face 106.2. La plaque 106 est en appui par sa première face 106.1 sur le boîtier. Dans l'exemple représenté, le boîtier comporte un épaulement 120 sur lequel repose la première face 106.2 de la plaque 106 par une surface annulaire 106.3 située radialement à l'extérieur. Des moyens élastiques 114 en appui contre la deuxième face 106.2 maintiennent en contact la surface annulaire 106.3 et l'épaulement.

Dans cet exemple, la pastille 12 étant mobile en rotation, son alimentation est réalisée par un contact électrique rotatif

Le dispositif D2 a pour avantage de n'utiliser qu'une partie active.

Le fonctionnement du dispositif D2 est similaire à celui du dispositif D1. La pastille 112 est excitée de sorte à faire vibrer le résonateur dans un mode dans le plan. Les vibrations sont transmises à au bord radial de la plaque 106 en contact avec l'épaulement 120. Un glissement transversal entre la plaque 106 et l'épaulement 120 apparaît, il en résulte une lubrification ultrasonique qui peut être modulée en fonction du motif haptique.

Sur la figure 6, on peut voir un autre exemple de réalisation d'un dispositif haptique D3. Le dispositif D3 comporte un seul résonateur 210 fixe dans le boîtier 202.

Le boîtier 202 comporte un fond 222 muni d'une saillie 224 sur laquelle repose la pastille piézoélectrique fixée à une plaque 206 ; la saillie 224 forme un contact électrique pour l'alimentation de la pastille. Le bouton comporte une structure 226 solidaire d'un côté du bouton 204 opposé à celui destiné à être manipulé par l'utilisateur. La structure est telle qu'elle permet la rotation du bouton par rapport au boîtier autour de la saillie 224 et entoure le résonateur. La structure 226 comporte une surface de contact 228 en contact avec une surface annulaire 206.3 radialement extérieure de la plaque 206. Dans cet exemple, la surface annulaire de contact 206.3 de la plaque 206 en contact avec le bouton est située sur la même face que la pastille piézoélectrique. La structure intègre également des moyens élastiques 214 maintenant en contact la plaque 206 et la surface de contact 228 solidaire du bouton.

Ce dispositif présente l'avantage de mettre en œuvre un résonateur fixe et de ne pas nécessiter de contact électrique rotatif.

Le fonctionnement du dispositif D3 est similaire à celui du dispositif de D2.

Sur la figure 11, on peut voir un autre exemple de bouton rotation D7, dans lequel le bouton est en contact linéique annulaire avec le résonateur.

Le résonateur 610 a une forme d'anneau suspendu sur le support et le bouton 604 comporte une base évasée 604.1 qui est en appui sur le bord intérieur 610.1 du résonateur 610. Lorsque le résonateur est excité, une lubrification apparaît entre la surface de la base évasée 604.1 et le bord intérieure 610.1 du résonateur.

Sur la figure 7, on peut voir un autre exemple de réalisation d'un dispositif haptique D4 dans lequel le bouton est mobile en translation.

Le dispositif D4 comporte un boîtier 302, un bouton 304 monté apte à coulisser le long d'une poutre 330 suspendue dans le boîtier 302.

Le dispositif comporte également une ou plusieurs éléments piézoélectriques 332 aptes à mettre en vibration la poutre 330. Dans l'exemple représenté, le dispositif comporte deux éléments en matériau piézoélectrique 312 de forme rectangulaire ou carrée fixés chacun à une extrémité longitudinale de la poutre 330. Le résonateur s'étend dans le plan de la poutre. Les vibrations générées sont parallèles au plan du résonateur.

Le bouton est tel qu'il entoure la poutre 330. De manière avantageuse, les moyens élastiques (non représentés) de précharge sont intégrés au bouton.

Le dispositif D4 est un exemple de réalisation non limitatif. Par exemple, on pourrait prévoir d'inverser la partie mobile et la partie fixe. Le fonctionnement est similaire à ceux des dispositifs déjà décrits. Une lubrification acoustique apparaît entre la poutre et le bouton.

En variante, le résonateur pourrait être intégré au bouton.

Sur la figure 8, on peut voir un autre exemple de réalisation d'un dispositif haptique D5 dans lequel l'élément d'interaction est formé par une sphère 404. Le résonateur 410 comporte une plaque 406 suspendue dans un boîtier 402 et comporte une cavité 434 de diamètre proche ou identique à celui de la sphère. Une pastille piézoélectrique 412 est fixée sur une face de la plaque 406 opposée à celle comportant la cavité 434.

Lorsque la pastille 412 est excitée, un effet de lubrification apparaît entre la surface de la cavité 434 et la surface extérieure de la sphère 404, et la sphère peut être déplacée plus ou moins facilement autour de son centre.

Sur la figure 10, on peut voir un autre exemple de réalisation d'un dispositif haptique D6 proche de celui de D5, il diffère de celui-ci en ce que le contact entre la sphère 504 et le résonateur 510 est un contact linéique annulaire. Le résonateur 510 a la forme d'un anneau dont le bord intérieur 511 sert d'appui pour la sphère. Lorsque le résonateur 510 est excité, un effet de lubrification apparait entre le bord 511 du résonateur et la sphère.

Dans le cas d'une interface haptique comportant un bouton mobile en rotation, on peut prévoir que celui-ci soit également mobile en translation le long de l'axe de rotation par exemple pour réaliser une action de sélection et/ou de validation.

Grâce à l'invention, on peut réaliser un dispositif haptique de type «bouton» rotatif ou une glissière linéaire, permettant de créer des crans et des butées reconfigurables. En effet, il est aisé de modifier l'effort de freinage appliqué à l'élément d'interaction en modifiant sur commande l'amplitude des vibrations dans le plan.

Un tel dispositif est de conception sensiblement plus simple que celle des interfaces tactiles, notamment en termes de capteur de force et de position et d'excitation ultrasonique. On évite en effet les problèmes de creux et nœuds de vibrations qui apparaissent lors d'une excitation résonante et qui sont gênant lors de l'utilisation de cet effet pour une surface tactile explorée avec le doigt. Certains effets locaux font que l'effet généré n'est pas présent partout sur la plaque.

## Revendications

1. Dispositif haptique comportant un support (2 ,102, 202, 302), un élément d'interaction avec l'utilisateur (4, 104, 204, 304) apte à être déplacé au moins en rotation et/ou en translation par rapport audit support (2 ,102, 202, 302), une première zone de contact solidaire en mouvement de l'élément d'interaction (4, 104, 204, 304), une deuxième zone de contact solidaire en mouvement du support (2 ,102, 202, 302), au moins un détecteur (16) de la position de l'élément d'interaction par rapport au support, au moins un premier résonateur (10, 110), une unité de commande (18) configurée pour exciter le résonateur à au moins une fréquence de résonance générant un mode de vibration dans le plan et l'apparition d'un phénomène de lubrification par vibration entre la première zone de contact et la deuxième zone de contact.

2. Dispositif haptique selon la revendication 1, dans lequel la fréquence de résonance est comprise entre 70 kHz et 200 kHz de sorte à générer une lubrification ultrasonique.

3. Dispositif haptique selon la revendication 1 ou 2, dans lequel le premier résonateur comporte une plaque (6, 106, 206) et une pastille en matériau apte à générer des vibrations (12, 112, 212) fixée à ladite plaque, l'une des faces de la première plaque (6, 106, 206) formant la première zone de contact ou la deuxième zone de contact.

4. Dispositif haptique selon la revendication 1 ou 2, dans lequel le premier résonateur comporte une plaque (8) et une pastille en un matériau apte à générer des vibrations (13) fixée à ladite plaque (8), l'une des faces de la première plaque (8) formant la première zone de contact et ledit dispositif comportant un deuxième résonateur comprenant une plaque (6) et une pastille en un matériau apte à générer des vibrations (12) fixée à ladite plaque (6), l'une des faces de la première plaque (6) formant la deuxième zone de contact.

5. Dispositif haptique selon l'une des revendications 1 à 4, dans lequel l'élément d'interaction (4, 104, 204) est apte à être déplacé en rotation et dans lequel la première zone de contact et/ou la deuxième zone de contact sont de forme annulaire.

6. Dispositif haptique selon la revendication 1 ou 2, dans lequel l'élément d'interaction (304) est apte à être déplacé en translation le long d'un axe longitudinal, la deuxième zone de contact étant portée par une poutre (330) suspendue au support (302) et s'étendant le long de l'axe longitudinal et au moins un élément en un matériau aptes à générer des vibrations (312) étant fixé à la poutre.

7. Dispositif haptique selon la revendication 6, dans lequel le capteur de position (16) est magnétique.

8. Dispositif haptique selon l'une des revendications 1 à 7, comportant un capteur de détection (23) de l'intention de l'utilisateur configuré pour détecter les forces exercées par l'utilisateur avant la rotation de l'élément d'interaction.

9. Dispositif haptique selon la revendication 8, dans lequel le capteur de détection (23) de l'intention d'action de l'utilisateur comporte un capteur de couple dans le cas d'un élément d'interaction mobile en rotation.

10. Dispositif haptique selon l'une des revendications 1 à 9, dans lequel le matériau apte à générer des vibrations est un matériau piézoélectrique.

11. Dispositif haptique selon l'une des revendications 1 à 10, dans lequel l'unité de commande (18) est un contrôleur électronique de type microcontrôleur, avantageusement associé à un amplificateur (20) et un contrôleur en fréquence (22).

12. Dispositif haptique selon l'une des revendications 1 à 11, dans lequel au moins l'une parmi les première et deuxième zones de contact est en laiton.

13. Dispositif haptique selon l'une des revendications 1 à 12, dans lequel les première et deuxième zones sont maintenues en contact l'une de l'autre par des moyens élastiques (14, 114, 214, 314).

## Patentansprüche

1. Haptische Vorrichtung, umfassend einen Träger (2, 102, 202, 302), ein Element zur Interaktion mit dem Benutzer (4, 104, 204, 304), das dazu ausgelegt ist, wenigstens in Rotation und/oder in Translation mit Bezug zu dem Träger (2, 102, 202, 302) verlagert zu werden, eine erste Kontaktzone, die zur Bewegung mit dem Interaktionselement (4, 104, 204, 304) verbunden ist, eine zweite Kontaktzone, die zur Bewegung mit dem Träger (2, 102, 202, 302) verbunden ist, wenigstens einen Detektor (16) für die Position des Interaktionselements mit Bezug zu dem Träger, wenigstens einen ersten Resonator (10, 110), eine Steuereinheit (18), die dazu konfiguriert ist, den Resonator bei wenigstens einer Resonanzfrequenz anzuregen, die eine Vibrationsmode in der Ebene und das Auftreten eines Schmierungsphänomens mittels Vibration zwischen der ersten Kontaktzone und der zweiten Kontaktzone erzeugt.

2. Haptische Vorrichtung nach Anspruch 1, bei der die Resonanzfrequenz zwischen 70 kHz und 200 kHz enthalten ist, derart, dass eine Ultraschallschmierung erzeugt wird.

3. Haptische Vorrichtung nach Anspruch 1 oder 2, bei der der erste Resonator eine Platte (6, 106, 206) und eine an der Platte befestigte Pastille aus einem Material umfasst, das dazu ausgelegt ist, Vibrationen (12, 112, 212) zu erzeugen, wobei die eine der Flächen der ersten Platte (6, 106, 206) die erste Kontaktzone oder die zweite Kontaktzone bildet.

4. Haptische Vorrichtung nach Anspruch 1 oder 2, bei der der erste Resonator eine Platte (8) und eine an der Platte (8) befestigte Pastille aus einem Material umfasst, das dazu ausgelegt ist, Vibrationen (13) zu erzeugen, wobei die eine der Flächen der ersten Platte (8) die erste Kontaktzone bildet, und wobei die Vorrichtung einen zweiten Resonator umfasst, der eine Platte (6) und eine an der Platte (6) befestigte Pastille aus einem Material umfasst, das dazu ausgelegt ist, Vibrationen (12) zu erzeugen, wobei die eine der Flächen der ersten Platte (6) die zweite Kontaktzone bildet.

5. Haptische Vorrichtung nach einem der Ansprüche 1 bis 4, bei der das Interaktionselement (4, 104, 204) dazu ausgelegt ist, in Rotation verlagert zu werden, und bei der die erste Kontaktzone und/oder die zweite Kontaktzone ringförmig sind.

6. Haptische Vorrichtung nach Anspruch 1 oder 2, bei der das Interaktionselement (304) dazu ausgelegt ist, in Translation entlang einer Längsachse verlagert zu werden, wobei die zweite Kontaktzone von einem Balken (330) getragen wird, der an dem Träger (302) aufgehängt ist und sich entlang der Längsachse erstreckt, und wobei wenigstens ein Element aus einem Material, das dazu ausgelegt ist, Vibrationen (312) zu erzeugen, an dem Balken befestigt ist.

7. Haptische Vorrichtung nach Anspruch 6, bei der der Positionssensor (16) magnetisch ist.

8. Haptische Vorrichtung nach einem der Ansprüche 1 bis 7, umfassend einen Sensor (23) zur Detektion der Intention des Benutzers, der dazu konfiguriert ist, die Kräfte zu detektieren, die durch den Benutzer vor der Rotation des Interaktionselements ausgeübt werden.

9. Haptische Vorrichtung nach Anspruch 8, bei der der Sensor (23) zur Detektion der Intention der Aktion des Benutzers im Fall eines Interaktionselements, das rotationsbeweglich ist, einen Drehmomentsensor umfasst.

10. Haptische Vorrichtung nach einem der Ansprüche 1 bis 9, bei der das Material, das dazu ausgelegt ist, Vibrationen zu erzeugen, ein piezoelektrisches Material ist.

11. Haptische Vorrichtung nach einem der Ansprüche 1 bis 10, bei der die Steuereinheit (18) ein elektronischer Controller vom Typ Mikrocontroller ist, der vorzugsweise einem Verstärker (20) und einem Frequenzcontroller (22) zugeordnet ist.

12. Haptische Vorrichtung nach einem der Ansprüche 1 bis 11, bei der die erste und/oder die zweite Kontaktzone aus Messing ist.

13. Haptische Vorrichtung nach einem der Ansprüche 1 bis 12, bei der die erste und die zweite Zone durch elastische Mittel (14, 114, 214, 314) in Kontakt miteinander gehalten werden.

## Claims

1. A haptic device comprising a support (2, 102, 202, 302), a user interaction element (4, 104, 204, 304) able to be at least rotationally and/or translationally moved with respect to said support (2, 102, 202, 302), a first contact zone movably secured to the interaction element (4, 104, 204, 304), a second contact zone movably secured to the support (2 ,102, 202, 302), at least one detector (16) of the position of the interaction element relative to the support, at least one first resonator (10, 110), a control unit (18) configured for energising the resonator at at least one resonance frequency generating an in-plane vibration mode and the occurrence of a vibration lubrication phenomenon between the first contact zone and the second contact zone.

2. The haptic device according to claim 1, wherein the resonance frequency is between 70 kHz and 200 kHz so as to generate an ultrasonic lubrication.

3. The haptic device according to claim 1 or 2, wherein the first resonator comprises a plate (6, 106, 206) and a pellet of a material able to generate vibrations (12, 112, 212) which is attached to said plate, one of the faces of the first plate (6, 106, 206) forming the first contact zone or the second contact zone.

4. The haptic device according to claim 1 or 2, wherein the first resonator comprises a plate (8) and a pellet of a material able to generate vibrations (13) which is attached to said plate (8), one of the faces of the first plate (8) forming the first contact zone and said device comprising a second resonator comprising a plate (6) and a pellet of a material able to generate vibrations (12) which is attached to said plate (6), one of the faces of the first plate (6) forming the second contact zone.

5. The haptic device according to one of claims 1 to 4, wherein the interaction element (4, 104, 204) is able to be rotationally moved and wherein the first contact zone and/or the second contact zone are of an annular shape.

6. The haptic device according to claim 1 or 2, wherein the interaction element (304) is able to be translationally moved along a longitudinal axis, the second contact zone being carried by a beam (330) suspended to the support (302) and extending along the longitudinal axis and at least one element of a material able to generate vibrations (312) being attached to the beam.

7. The haptic device according to claim 6, wherein the position sensor (16) is magnetic.

8. The haptic device according to one of claims 1 to 7, comprising a sensor of detecting the user's intention (23) configured for detecting the forces exerted by the user before the interaction element is rotated.

9. The haptic device according to claim 8, wherein the sensor of detecting the user's action intention (23) comprises a torque sensor in the case of a rotationally movable interaction element.

10. The haptic device according to one of claims 1 to 9, wherein the material able to generate vibrations is a piezoelectric material.

11. The haptic device according to one of claims 1 to 10, wherein the control unit (18) is a microcontroller type electronic controller, advantageously associated with an amplifier (20) and a frequency controller (22).

12. The haptic device according to one of claims 1 to 11, wherein at least one from the first and the second contact zones is of brass.

13. The haptic device according to one of claims 1 to 12, wherein the first and second zones are held in contact with each other by elastic means (14, 114, 214, 314).
